# EUROPEAN PATENT APPLICATION

(11) **EP 2 800 124 A1**
(43) Date of publication of application: **05.11.2014**
(21) Application number: 12862165.3
(22) Date of filing: 25.12.2012
(51) Int. Cl.: H01L 21/304, B24B 37/00, C09K 3/14

(54) **POLISHING COMPOSITION**

(30) Priority: 28.12.2011 JP 2011287264
(71) Applicant: Fujimi Incorporated, Kiyosu-shi, Aichi 452-8502 (JP)
(72) Inventor: YOKOTA, Shuugo, Kiyosu-shi Aichi 452-8502 (JP); KACHI, Yoshihiro, Kiyosu-shi Aichi 452-8502 (JP); AKATSUKA, Tomohiko, Kiyosu-shi Aichi 452-8502 (JP)
(74) Representative: Grünecker, Kinkeldey, Stockmair & Schwanhäusser
(86) International application number: PCT/JP2012/083472
(87) International publication number: WO 2013/099866

(57) **Abstract**

A polishing composition of the present invention is to be used for polishing an object including a metal portion or an interlayer insulation film. The polishing composition contains silica on which an organic acid, such as a sulfonic acid and a carboxylic acid, is immobilized and an oxidizing agent.

## Description

### TECHNICAL FIELD

The present invention relates to a polishing composition to be used in, for example, a semiconductor device manufacturing process and to a polishing method using the polishing composition.

### BACKGROUND ART

A conventional polishing composition to be used in a semiconductor device manufacturing process and in particular to be used for polishing wiring metal and an interlayer insulation film contains abrasive grains, an acid, and oxidizing agent. For example, Patent document 1 discloses a polishing composition containing abrasive grains, an oxidizing agent, a protective film-forming agent (anticorrosive agent), an acid, and water and having a pH of 3 or less. Patent document 2 discloses a metal polishing composition containing an oxidizing agent and colloidal silica at least a part of superficial silicon atoms of which is substituted with an aluminum atom.

However, the polishing compositions described above have problems of insufficient storage stability and of high contents of metal impurities. In addition, it is desirable to be able to suppress defects, such as scratches, generated on the surfaces polished with the polishing compositions. There is room for further improvement in the polishing compositions and other conventional polishing compositions in order to solve the problems while keeping or enhancing the rate of polishing metal.

### PRIOR ART DOCUMENTS

Patent document 1: Japanese Laid-Open Patent Publication No. 2009-152647
Patent document 2: Japanese Laid-Open Patent Publication No. 2007-207785

### SUMMARY OF THE INVENTION

### Problems that the Invention is to Solve

Accordingly, it is an objective of the present invention to provide a polishing composition having high storage stability as well as capable of polishing metal at a higher polishing rate and capable of polishing an interlayer insulation film with fewer defects such as scratches, and to provide a polishing method using the polishing composition.

### Means for Solving the Problems

As a result of intensive investigation, the present inventors have found that a polishing composition containing specific abrasive grains and an oxidizing agent has high storage stability and that upon using the polishing composition metal can be polished at a higher rate and an interlayer insulation film can be polished with fewer scratches and other defects.

That is, in order to achieve the objective described above and in accordance with one aspect of the present invention, provided is a polishing composition to be used for polishing an object including a metal portion or an interlayer insulation film. The polishing composition contains silica on which an organic acid is immobilized and an oxidizing agent.

The polishing composition may further contain a salt.

The salt is preferably an ammonium salt.

The polishing composition may further contain an anticorrosive agent.

The polishing composition has a pH of preferably 6 or less.

In accordance with another aspect of the present invention, provided is a method for polishing an object including a metal portion or an interlayer insulation film with the polishing composition according to the aspect described above.

In accordance with still another aspect of the present invention, a method for producing a polished substrate is provided that includes the step of polishing an object including a metal portion or an interlayer insulation film with the polishing composition according to the aspect described above.

### Effects of the Invention

The present invention succeeds in providing high storage stability as well as in polishing metal at a higher polishing rate and in polishing an interlayer insulation film with fewer scratches and other defects.

### MODES FOR CARRYING OUT THE INVENTION

One embodiment of the present invention will be described below.

A polishing composition of the present embodiment is prepared by mixing specific abrasive grains and an oxidizing agent with water.

The polishing composition is mainly used for polishing an object including a metal portion or an interlayer insulation film, namely, the surface including a metal portion and an interlayer insulation film of a semiconductor wiring substrate or other objects, and more specifically for polishing the surface of such an object to produce a polished substrate. Examples of the metal portion include those composed of a wiring material, such as copper, aluminum, tungsten, tantalum, titanium, titanium nitride, tantalum nitride, and ruthenium. Examples of the interlayer insulation film include those composed of a silicon material, such as polysilicon, silicon oxide, and silicon nitride.

### (Abrasive grains)

The abrasive grains contained in the polishing composition are silica having an organic acid immobilized on the particle surfaces thereof. Among such silica, colloidal silica on which an organic acid is immobilized is preferable. The immobilization of an organic acid to the particle surfaces of colloidal silica is carried out by chemically bonding a functional group of the organic acid to the particle surfaces of the colloidal silica. The immobilization of an organic acid on colloidal silica cannot be accomplished by only allowing the colloidal silica and the organic acid to coexist. The immobilization of a sulfonic acid, which is one of organic acids, on colloidal silica can be carried out, for example, by the method described in Japanese Laid-Open Patent Publication No. 2010-269985 or "Sulfonic acid-functionalized silica through quantitative oxidation of thiol groups", Chem. Commun. 246-247 (2003). Specifically, colloidal silica having a sulfonic acid immobilized on the particle surfaces thereof can be obtained by coupling a silane coupling agent having a thiol group, such as 3-mercaptopropyl trimethoxysilane, to colloidal silica, followed by oxidizing the thiol group with hydrogen peroxide. The immobilization of a carboxylic acid on colloidal silica can be carried out, for example, by the method described in "Novel Silane Coupling Agents Containing a Photolabile 2-Nitrobenzyl Ester for Introduction of a Carboxy Group on the Surface of Silica Gel", Chemistry Letters, 3, 228-229 (2000). Specifically, colloidal silica having a carboxylic acid immobilized on the particle surfaces thereof can be obtained by coupling a silane coupling agent containing photoreactive 2-nitrobenzyl ester to colloidal silica, followed by photoirradiation.

The average primary particle diameter of the silica in the polishing composition is preferably 5 nm or more, more preferably 7 nm or more, and still more preferably 10 nm or more. As the average primary particle diameter of the silica increases, the polishing rate of an interlayer insulation film with the polishing composition is advantageously enhanced.

The average primary particle diameter of the silica in the polishing composition is also preferably 100 nm or less, more preferably 90 nm or less, and still more preferably 80 nm or less. As the average primary particle diameter of the silica decreases, the occurrence of scratches on a polished surface obtained by polishing the object with the polishing composition is advantageously suppressed. The average primary particle diameter of the silica is calculated, for example, based on the specific surface area of the silica determined by the BET method.

The average secondary particle diameter of the silica in the polishing composition is preferably 10 nm or more, more preferably 20 nm or more, and still more preferably 30 nm or more. As the average secondary particle diameter of the silica increases, the polishing rate of an interlayer insulation film with the polishing composition is advantageously enhanced.

The average secondary particle diameter of the silica in the polishing composition is also preferably 200 nm or less, more preferably 170 nm or less, and still more preferably 150 nm or less. As the average secondary particle diameter of the silica decreases, the occurrence of scratches on a polished surface obtained by polishing the object with the polishing composition is advantageously suppressed. The average secondary particle diameter of the silica is determined, for example, by the light scattering method using laser light.

The shape of the silica in the polishing composition is preferably non-spherical. The non-spherical silica may be that formed through association of two or more primary particles.

The average degree of association of the silica in the polishing composition is preferably 1.2 or more, and more preferably 1.5 or more. As the average degree of association of the silica increases, the polishing rate of an interlayer insulation film with the polishing composition is advantageously enhanced.

The average degree of association of the silica in the polishing composition is also preferably 4.0 or less, more preferably 3.5 or less, and still more preferably 3.0 or less. As the average degree of association of the silica decreases, the occurrence of defects and increased roughness on a polished surface obtained by polishing the object with the polishing composition is advantageously suppressed.

The content of the silica in the polishing composition is preferably 0.05% by mass or more, more preferably 0.1% by mass or more, and still more preferably 1% by mass or more. As the silica content increases, the polishing rate of an interlayer insulation film with the polishing composition is advantageously enhanced.

The content of the silica in the polishing composition is also preferably 20% by mass or less, more preferably 17% by mass or less, and still more preferably 15% by mass or less. As the silica content decreases, the material cost of the polishing composition is reduced.

### (Oxidizing agent)

The oxidizing agent contained in the polishing composition has a function of helping polish the object with the abrasive grains through oxidizing the surface of the object to be polished, particularly the surface of a metal portion thereof. Examples of the oxidizing agent include hydrogen peroxide, metal oxides, peroxides, nitrates, iodates, periodates, hypochlorites, chlorites, chlorates, perchlorates, persulfates, bichromates, permanganates, organic oxidizing agents, ozone water, silver (II) salts, and iron (III) salts. Hydrogen peroxide, periodic acid, or Oxone is preferably used.

### (pH)

The pH value of the polishing composition is not particularly limited, but is preferably 6 or less. When the polishing composition has a pH of 6 or less, prolonged excellent dispersion stability is obtained, and also the polishing rate of an interlayer insulation film with the polishing composition is enhanced. In addition, if a metal portion of the object to be polished is composed of tungsten, it is possible to suppress the occurrence of pattern failures, such as steps and seams, caused by dissolution of the tungsten by the polishing composition.

A pH-adjusting agent may be used to adjust the pH of the polishing composition to a desired value. The type of the pH regulating agent used is not particularly limited, and may be any of inorganic acids, organic acids, chelating agents, alkalis, and salts thereof. Two or more types of pH-adjusting agents may be used in combination. In the case where a weak acid is used in combination with a strong base, a strong acid is used in combination with a weak base, or a weak acid is used in combination with a weak base, a pH-buffering effect is expected.

According to the present embodiment, the following advantages are obtained.
- The polishing composition of the present embodiment contains silica on which an organic acid, such as a sulfonic acid and a carboxylic acid, is immobilized and an oxidizing agent. Particularly when the the polishing composition has a pH of 6 or less, it is possible to obtain prolonged excellent dispersion stability. The reason for this is that colloidal silica on which an organic acid is immobilized has a negative zeta potential and tends to have a higher absolute zeta potential value in a polishing composition than common colloidal silica, on which no organic acids are immobilized. As the absolute value of the zeta potential in the polishing composition increases, electrostatic repulsion between silica particles is enhanced, and thus agglomeration of the colloidal silica is less likely to occur. As a result, the dispersion stability of the polishing composition is improved, and thereby enhancing the storage stability. It is also possible to prevent the occurrence of scratches on the surface of the object to be polished due to the agglomerated silica. In an acidic pH region, colloidal silica on which an organic acid is immobilized typically exhibits a negative zeta potential value of -15 mV or less, whereas common colloidal silica exhibits a zeta potential value close to zero.
- When the oxidizing agent is present in the polishing composition, the surface of a metal portion of the object to be polished is oxidized with the oxidizing agent so as to become positively charged. In addition, when the pH of the polishing composition is 6 or less, the zeta potential of the surface of an interlayer insulation film, such as silicon nitride, also becomes positive. As a result, static attraction acts between the positively charged surface of the metal portion or the interlayer insulation film and colloidal silica having a negative zeta potential at pH of 6 or less on which an organic acid is immobilized, so that the mechanical polishing ability is enhanced. Thus, the metal portion or the interlayer insulation film of the object to be polished is easy to be removed. That is, according to the present embodiment, it is possible to polish the metal portion or the interlayer insulation film of the object to be polished at a high rate, and additionally to polish the interlayer insulation film with fewer defects such as scratches.
- When the average primary particle diameter of the silica in the polishing composition is 5 nm or more, and more specifically 7 nm or more or 10 nm or more, the polishing rate of the interlayer insulation film can be further enhanced.
- When the average primary particle diameter of the silica in the polishing composition is 100 nm or less, and more specifically 90 nm or less or 80 nm or less, the occurrence of scratches on a polished surface obtained by polishing the object with the polishing composition can be satisfactory suppressed.
- When the average secondary particle diameter of the silica in the polishing composition is 10 nm or more, and more specifically 20 nm or more or 30 nm or more, the polishing rate of the interlayer insulation film can be further enhanced.
- When the average secondary particle diameter of the silica in the polishing composition is 200 nm or less, and more specifically 170 nm or less or 150 nm or less, the occurrence of scratches on a polished surface obtained by polishing the object with the polishing composition can be satisfactory suppressed.
- When the shape of the silica in the polishing composition is non-spherical, the polishing rate of the interlayer insulation film can be further enhanced.
- When the average degree of association of the silica in the polishing composition is 1.2 or more, and more specifically 1.5 or more, the polishing rate of the interlayer insulation film can be further enhanced.
- When the average degree of association of the silica in the polishing composition is 4.0 or less, and more specifically 3.5 or less or 3.0 or less, the occurrence of defects and increased roughness on a polished surface obtained by polishing the object with the polishing composition can be satisfactorily suppressed.
- When the content of the silica in the polishing composition is 0.05% by mass or more, and more specifically 0.1% by mass or more or 1% by mass or more, the polishing rate of the interlayer insulation film can be further enhanced.
- When the content of the silica in the polishing composition is 20% by mass or less, and more specifically 17% by mass or less or 15% by mass or less, the material cost of the polishing composition can be reduced.
- When the pH value of the polishing composition is 6 or less, the dissolution of metal such as tungsten can be suppressed.

The embodiment described above may be modified as follows.
- The polishing composition of the embodiment described above may further contain a salt. Addition of a salt makes the electric double layer of the silica in the polishing composition smaller, so that repulsion between the silica and the interlayer insulation film is reduced. As a result, the polishing rate of the interlayer insulation film with the polishing composition is enhanced. As used herein, the term salt refers to a compound formed through an ionic bonding of an anion derived from an acid and a cation derived from a base. The salt is preferably an ammonium salt from the viewpoint of metal impurities, and more preferably ammonium chloride, ammonium perchlorate, ammonium sulfate, ammonium nitrate, ammonium carbonate, or ammonium acetate.
- The polishing composition of the embodiment described above may further contain an anticorrosive agent. An anticorrosive agent relieves the oxidation of the surface of the object to be polished by the oxidizing agent and acts to react with metal ions, which are produced through the oxidation of metal of the surface of the object by the oxidizing agent, to form an insoluble complex. These actions of an anticorrosive agent improve the flatness of a polished surface obtained by polishing the object with the polishing composition. The type of an anticorrosive agent that can be used is not particularly limited, but is preferably a heterocyclic compound. The number of members in the heterocyclic ring in the heterocyclic compound is not particularly limited. The heterocyclic compound may be a monocyclic compound or a polycyclic compound having a condensed ring. Specific examples of the heterocyclic compound include nitrogen-containing heterocyclic compounds, such as pyrroles, pyrazoles, imidazoles, triazoles, tetrazoles, pyridines, pyrazines, pyridazines, pyrindines, indolizines, indoles, isoindoles, indazoles, purines, quinolizines, quinolines, isoquinolines, naphthyridines, phthalazines, quinoxalines, quinazolines, cinnolines, buterizines, thiazoles, isothiazoles, oxazoles, isoxazoles, and frazans. Examples of pyrazoles include 1H-pyrazole, 4-nitro-3-pyrazolecarboxylic acid, 3,5-pyrazolecarboxylic acid, 3-amino-5-phenylpyrazole, 5-amino-3-phenylpyrazole, 3,4,5-tribromopyrazole, 3-aminopyrazole, 3,5-dimethylpyrazole, 3,5-dimethyl-1-hydroxymethylpyrazole, 3-methylpyrazole, 1-methylpyrazole, 3-amino-5-methylpyrazole, 4-amino-pyrazolo[3,4-d]pyrimidine, allopurinol, 4-chloro-1H-pyrazolo[3,4-D]pyrimidine, 3,4-dihydroxy-6-methylpyrazolo(3,4-B)-pyridine, and 6-methyl-1H-pyrazolo[3,4-b]pyridin-3-amine. Examples of imidazoles include imidazole, 1-methylimidazole, 2-methylimidazole, 4-methylimidazole, 1,2-dimethylpyrazole, 2-ethyl-4-methylimidazole, 2-isopropylimidazole, benzimidazole, 5,6-dimethylbenzimidazole, 2-aminobenzimidazole, 2-chlorobenzimidazole, 2-methylbenzimidazole, 2-(1-hydroxyethyl) benzimidazole, 2-hydroxybenzimidazole, 2-phenylbenzimidazole, 2,5-dimethylbenzimidazole, 5-methylbenzimidazole, 5-nitrobenzimidazole, and 1H-purine. Examples of triazoles include 1,2,3-triazole, 1,2,4-triazole, 1-methyl-1,2,4-triazole, methyl-1H-1,2,4-triazole-3-carboxylate, 1,2,4-triazole-3-carboxylic acid, 1,2,4-triazole-3-methyl carboxylate, 1 H-1,2,4-triazole-3-thiol, 3,5-diamino-1H-1,2,4-triazole, 3-amino-1,2,4-triazole-5-thiol, 3-amino-1H-1,2,4-triazole, 3-amino-5-benzyl-4H-1,2,4-triazole, 3-amino-5-methyl-4H-1,2,4-triazole, 3-nitro-1,2,4-triazole, 3-bromo-5-nitro-1,2,4-triazole, 4-(1,2,4-triazole-1-yl)phenol, 4-amino-1,2,4-triazole, 4-amino-3,5-dipropyl-4H-1,2,4-triazole, 4-amino-3,5-dimethyl-4H-1,2,4-triazole, 4-amino-3,5-dipeptyl-4H-1,2,4-triazole, 5-methyl-1,2,4-triazole-3,4-diamine, 1H-benzotriazole, 1-hydroxybenzotriazole, 1-aminobenzotriazole, 1-carboxybenzotriazole, 5-chloro-1 H-benzotriazole, 5-nitro-1H-benzotriazole, 5-carboxy-1H-benzotriazole, 5-metyl-1 H-benzotriazole, 5,6-dimethyl-1 H-benzotriazole, 1-(1',2'-dicarboxyethyl)benzotriazole, 1-[N,N-bis(hydroxyethyl)aminomethyl]benzotriazole, and 1-[N,N-bis(hydroxyethyl)aminomethyl]-5-methylbenzotriazole. Examples of tetrazoles include 1H-tetrazole, 5-methyltetrazole, 5-aminotetrazole, and 5-phenyltetrazole. Examples of indazoles include 1 H-indazole, 5-amino-1H-indazole, 5-nitro-1H-indazole, 5-hydroxy-1H-indazole, 6-amino-1H-indazole, 6-nitro-1H-indazole, 6-hydroxy-1H-indazole, and 3-carboxy-5-methyl-1H-indazole. Examples of indoles include 1 H-indole, 1-methyl-1 H-indole, 2-methyl-1H-indole, 3-methyl-1 H-indole, 4-methyl-1 H-indole, 5-methyl-1 H-indole, 6-methyl-1 H-indole, 7-methyl-1 H-indole, 4-amino-1H-indole, 5-amino-1H-indole, 6-amino-1H-indole, 7-amino-1H-indole, 4-hydroxy-1H-indole, 5-hydroxy-1H-indole, 6-hydroxy-1 H-indole, 7-hydroxy-1H-indole, 4-methoxy-1H-indole, 5-methoxy-1H-indole, 6-methoxy-1H-indole, 7-methoxy-1H-indole, 4-chloro-1 H-indole, 5-chloro-1 H-indole, 6-chloro-1 H-indole, 7-chloro-1 H-indole, 4-carboxy-1H-indole, 5-carboxy-1H-indole, 6-carboxy-1H-indole, 7-carboxy-1H-indole, 4-nitro-1H-indole, 5-nitro-1H-indole, 6-nitro-1H-indole, 7-nitro-1H-indole, 4-nitrile-1 H-indole, 5-nitrile-1 H-indole, 6-nitrile-1 H-indole, 7-nitrile-1 H-indole, 2,5-dimethyl-1 H-indole, 1,2-dimethyl-1 H-indole, 1,3-dimethyl-1H-indole, 2,3-dimethyl-1 H-indole, 5-amino-2,3-dimethyl-1H-indole, 7-ethyl-1 H-indole, 5-(aminomethyl)indole, 2-methyl-5-amino-1H-indole, 3-hydroxymethyl-1H-indole, 6-isopropyl-1 H-indole, and 5-chloro-2-methyl-1 H-indole. Among them, preferable anticorrosive agents are 3-amino-5-phenylpyrazole, 1H-benzotriazole, 5-metyl-1 H-benzotriazole, 5,6-dimethyl-1 H-benzotriazole, 1-[N,N-bis(hydroxyethyl)aminomethyl]-5-methylbenzotriazole, 1,2,4-triazole, and 5-nitro-1H-indole.

The content of the anticorrosive agent in the polishing composition is preferably 0.001 g/L or more, more preferably 0.01 g/L or more, and still more preferably 0.1 g/L or more. As the anticorrosive agent content increases, the flatness of a polished surface obtained by polished the object with the polishing composition is improved.

The content of the anticorrosive agent in the polishing composition is also preferably 5 g/L or less, more preferably 2 g/L or less, and still more preferably 1 g/L or less. As the anticorrosive agent content decreases, the polishing rate of the object to be polished with the polishing composition is enhanced.
- The polishing composition of the embodiment described above may further contain a water-soluble polymer. A water-soluble polymer can be adsorbed on the surface of the colloidal silica or the surface of the object to be polished to control the polishing rate of the object with the polishing composition, and additionally has a function of stabilizing an insoluble component generated during polishing in the polishing composition. Examples of a water-soluble polymer that can be used include compounds having a polyoxyalkylene chain, more specifically polyethylene glycol, polypropylene glycol, polyoxyethylene alkyl ether, polyoxyethylene lauryl ether sulfate, polyoxyethylene lauryl ether acetate, polyoxyethylene alkyl phosphoric acid, and silicone oil having a polyoxyalkylene chain. Among them, polyethylene glycol and polypropylene glycol are preferred.
- The polishing composition of the embodiment described above may further contain a complexing agent. A complexing agent has a function of chemically etching the surface of the object to be polished and acts to enhance the polishing rate of the object with the polishing composition.

The content of the complexing agent in the polishing composition is preferably 0.01% by mass or more, more preferably 0.05% by mass or more, and still more preferably 0.1% by mass or more. As the complexing agent content increases, the etching effect to the surface of the object to be polished is enhanced. As a result, the polishing rate of the object with the polishing composition is enhanced.

The content of the complexing agent in the polishing composition is also preferably 50% by mass or less, more preferably 45% by mass or less, and still more preferably 40% by mass or less. As the complexing agent content decreases, the excessive etching to the surface of the object to be polished is less likely to occur, so that the flatness of a polished surface of the object is improved.

A complexing agent that can be used is, for example, an inorganic acid, an organic acid, or an amino acid. Specific examples of inorganic acids include sulfuric acid, nitric acid, boric acid, carbonic acid, hypophosphorous acid, phosphorous acid, and phosphoric acid. Specific examples of organic acids include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid. An organic sulfuric acid, such as methanesulfonic acid, ethanesulfonic acid, and isethionic acid, is also usable. A salt, such as an ammonium salt and alkali metal salt, of an inorganic acid or organic acid may be used, either instead of an inorganic acid or organic acid or in combination with an inorganic acid or organic acid. Specific examples of amino acids include glycine, α-alanine, β-alanine, N-methylglycine, N,N-dimethylglycine, 2-aminobutyric acid, norvaline, valine, leucine, norleucine, isoleucine, phenylalanine, proline, sarcocine, ornithine, lysine, taurine, serine, threonine, homoserine, tyrosine, bicine, tricine, 3,5-diiodo-tyrosine, β-(3,4-dihydroxyphenyl)-alanine, thyroxine, 4-hydroxy-proline, cysteine, methionine, ethionine, lanthionine, cystathionine, cystine, cysteic acid, aspartic acid, glutaminic acid, S-(carboxymethyl)-cysteine, 4-aminobutyric acid, asparagine, glutamine, azaserine, arginine, canavanine, citrulline, δ-hydroxy-lysine, creatine, histidine, 1-methyl-histidine, 3-methyl-histidine, and tryptophan. Among them, glycine, alanine, malic acid, tartaric acid, citric acid, glycolic acid, isethionic acid, and an ammonium salt or alkali metal salt thereof are preferred as a complexing agent from the viewpoint of polishing rate improvement.
- The polishing composition of the embodiment described above may further contain a known additive such as a preservative agent and antifungal agent as necessary. Specific examples of preservative agents and antifungal agents include isothiazolin preservative agents, such as 2-methyl-4-isothiazolin-3-one and 5-chloro-2-methyl-4-isothiazolin-3-one, paraoxybenzoates, and phenoxyethanol.
- The polishing composition of the embodiment described above may be of a one-pack type or may be of a multi-pack type, such as two-pack type.
- The polishing composition of the embodiment described above may be prepared by diluting an undiluted solution of the polishing composition, for example, to 10 times or more with a diluting liquid, such as water.

Next, examples of the present invention and comparative examples will be described.

Polishing compositions of Examples 1 to 6 and Comparative Examples 1 and 2 were each prepared by mixing abrasive grains and an oxidizing agent, and a salt, anticorrosive agent, and pH-adjusting agent as required, with water. The details of the components in each of the polishing compositions and the results obtained by measuring the pH of each polishing composition are shown in Table 1. The expression "-" in Table 1 represents not containing the corresponding component.

Although the type of abrasive grains contained in each polishing composition is not shown in Table 1, colloidal silica on which sulfonic acid is immobilized (average primary particle diameter: 35 nm, average secondary particle diameter: 70 nm, average degree of association: 2) was used in the polishing compositions of Examples 1 to 6, and colloidal silica on which no organic acids are immobilized (average primary particle diameter: 35 nm, average secondary particle diameter: 70 nm, average degree of association: 2) was used in the polishing compositions of Comparative Examples 1 and 2.

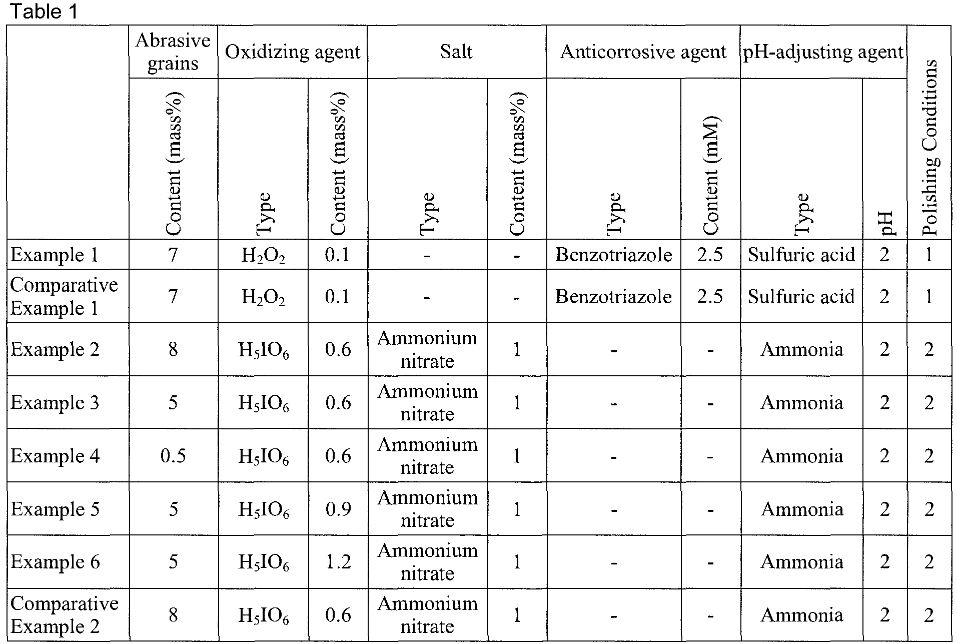

Wafer polishing tests were performed using the polishing compositions of Examples 1 to 6 and Comparative Examples 1 and 2 under the conditions shown in Table 2. As shown in Table 1, the polishing tests using the polishing compositions of Example 1 and Comparative Example 1 were performed under Polishing Conditions 1 shown in Table 2. On the other hand, the polishing tests using the polishing compositions of Examples 2 to 6 and Comparative Example 2 were performed under Polishing Conditions 2 shown in Table 2. The thicknesses of each wafer before and after polishing were determined from the measurement of sheet resistance by the direct current four-probe method, and the polishing rate was calculated by dividing the difference between the thicknesses of the wafer before and after polishing by the polishing time. The calculated polishing rate values are shown in the column entitled "polishing rate" of Table 3 by type of wafer.

The column entitled "storage stability" of Table 3 shows the results of storage stability evaluation for the polishing compositions of Examples 1 to 6 and Comparative Examples 1 and 2. The storage stability of each polishing composition was evaluated by comparing between the polishing rate of a TEOS blanket film wafer with the polishing composition stored at 70°C for one week and the polishing rate the same wafer with the polishing composition stored at 25°C for one week. A case where the difference between the compared polishing rates was less than 10% was evaluated as "Good (○)" and a case where the difference between the compared polishing rates was 10% or more was evaluated as "Poor (×)".

The column entitled "number of scratches" of Table 3 shows the results of measuring the number of scratches on a TEOS blanket film wafer caused by polishing the wafer with each of the polishing composition of Examples 2 to 6 and Comparative Example 2. Specifically, the polished wafer surfaces were observed using a commercially available wafer surface inspection apparatus, and scratches of 0.13 µm or more in size were counted. An expression "-" in this column represents that the measurement of the number of scratches has not been performed.

**Table 2**

| Polishing Conditions 1 |
|---|
| Polishing machine: One-side CMP polisher adaptable to wafer with 300 mm diameter |
| Polishing pad: Suede type CMP pad, Fujibo Holdings, Inc. |
| Polishing pressure: 1.5 psi |
| Platen rotational frequency: 83 rpm |
| Head rotational frequency: 77 rpm |
| Feeding rate of polishing composition: 300 mL/min |
| Polishing object: Blanket film wafer composed of copper (Cu), tantalum (Ta), ruthenium (Ru), titanium nitride (TiN), or tetraethoxysilane (TEOS) |
| |
| Polishing Conditions 2 |
| Polishing machine: One-side CMP polisher adaptable to wafer with 200 mm diameter |
| Polishing pad: CMP pad made of polyurethane, Rohm and Haas Company |
| Polishing pressure: 2.5 psi |
| Platen rotational frequency: 93 rpm |
| Head rotational frequency: 87 rpm |
| Feeding rate of polishing composition: 185 mL/min |
| Polishing object: Blanket film wafer composed of tungsten (W) or tetraethoxysilane (TEOS) |

**Table 3**

| | Polishing rate [Å/min] | | | | | | Storage stability | Number of scratches |
|---|---|---|---|---|---|---|---|---|
| | Cu | Ta | Ru | W | TiN | TEOS | | |
| Example 1 | 486 | 725 | 239 | - | 1171 | 472 | ○ | - |
| Comparative Example 1 | 324 | 522 | 166 | - | 746 | 867 | × | - |
| Example 2 | - | - | - | 1239 | - | 822 | ○ | 26 |
| Example 3 | - | - | - | 856 | - | 630 | ○ | 25 |
| Example 4 | - | - | - | 455 | - | 100 | ○ | 21 |
| Example 5 | - | - | - | 928 | - | 639 | ○ | 22 |
| Example 6 | - | - | - | 972 | - | 654 | ○ | 27 |
| Comparative Example 2 | - | - | - | 1031 | - | 978 | × | 47 |

As shown in Table 3, it has been recognized that when the polishing compositions of Examples 1 to 6 are used, high polishing rates and satisfactory storage stability are obtained, and additionally, the occurrence of scratches is suppressed comparing with the case in which the polishing compositions of Comparative Examples 1 and 2 not containing silica on which an organic acid is immobilized are used.

## Claims

1. A polishing composition to be used for polishing an object including a metal portion or an interlayer insulation film, the polishing composition comprising silica on which an organic acid is immobilized and an oxidizing agent.

2. The polishing composition according to claim 1, further comprising a salt.

3. The polishing composition according to claim 2, wherein the salt is an ammonium salt.

4. The polishing composition according to claim 1, further comprising an anticorrosive agent.

5. The polishing composition according to any one of claims 1 to 4, wherein the polishing composition has a pH of 6 or less.

6. A method for polishing, comprising polishing an object including a metal portion or an interlayer insulation film with the polishing composition according to any one of claims 1 to 5.

7. A method for producing a polished substrate, comprising the step of polishing an object including a metal portion or an interlayer insulation film with the polishing composition according to any one of claims 1 to 5.
